# EUROPEAN PATENT APPLICATION

(11) **EP 4 391 094 A1**
(43) Date of publication of application: **26.06.2024**
(21) Application number: 23219385.4
(22) Date of filing: 21.12.2023
(51) Int. Cl.: H01L 33/50, H01L 33/52, H01L 33/58

(54) **LIGHT-EMITTING DIODE PACKAGE**

(30) Priority: 23.12.2022 KR 20220183495
(71) Applicant: Samsung Electronics Co., Ltd., Suwon-si, Gyeonggi-do 16677 (KR)
(72) Inventor: JUNG, Seunggyun, 16677 Suwon-si, Gyeonggi-do (KR); KIM, Heejin, 16677 Suwon-si, Gyeonggi-do (KR); WON, Ilseop, 16677 Suwon-si, Gyeonggi-do (KR); KIM, Youngkyung, 16677 Suwon-si, Gyeonggi-do (KR); YOON, Chulsoo, 16677 Suwon-si, Gyeonggi-do (KR)
(74) Representative: Kuhnen & Wacker Patent- und Rechtsanwaltsbüro PartG mbB

(57) **Abstract**

A light-emitting diode package includes a substrate, a light-emitting diode chip mounted on the substrate, a phosphor surrounding a side surface and an upper surface of the light-emitting diode chip, a light conversion structure disposed on the phosphor, and a transparent element disposed between the phosphor and the light conversion structure.

## Description

### BACKGROUND

### 1. Field

Embodiments relate to a light-emitting diode package, and more particularly, to a light-emitting diode package which emits directional light.

### 2. Description of the Related Art

A light-emitting device is a type of a semiconductor device which converts electrical energy into light energy. Light-emitting devices have advantages such as low power consumption, semi-permanent lifetime, fast response time, stability, and eco-friendly compatibility, compared to conventional light sources such as fluorescent lamps and incandescent lamps. Therefore, research for replacing conventional light sources with light-emitting devices is being done, and use of light-emitting devices as light sources for lighting devices, e.g., various lamps, liquid crystal display devices, electric sign boards, and streetlamps, increases.

### SUMMARY

According to an aspect of embodiments, there is provided a light-emitting diode package including a substrate, a light-emitting diode chip mounted on the substrate, a phosphor surrounding a side surface and an upper surface of the light-emitting diode chip, a light conversion structure disposed on the phosphor, and a transparent element disposed between the phosphor and the light conversion structure.

According to another aspect of embodiments, there is provided a light-emitting diode package including a substrate, a light-emitting diode chip mounted on the substrate, a phosphor surrounding a side surface and an upper surface of the light-emitting diode chip, a first transparent element covering a side surface and an upper surface of the phosphor and having a shape where a valley is formed in an upper portion of a center of the light-emitting diode chip, a second transparent element surrounding the first transparent element, and a light conversion structure filling the valley of the first transparent element and covering an upper surface of the second transparent element, wherein a lower surface of the light conversion structure has a shape which protrudes downward toward the center of the light-emitting diode chip.

According to another aspect of embodiments, there is provided a light-emitting diode package including a substrate, a light-emitting diode chip mounted on the substrate, a phosphor surrounding a side surface and an upper surface of the light-emitting diode chip and including a wavelength conversion material, a first transparent element covering a side surface and an upper surface of the phosphor and having a shape where a valley is formed in an upper portion of a center of the light-emitting diode chip, a second transparent element surrounding the first transparent element and having a refractive index which is higher than a refractive index of the first transparent element, a light conversion structure filling the valley of the first transparent element and covering an upper surface of the second transparent element, wherein a lower surface of the light conversion structure has a shape which protrudes downward toward a center of the light-emitting diode chip, the light conversion structure and the phosphor are apart from each other in a vertical direction, and a shortest distance between the lower surface of the light conversion structure and the upper surface of the phosphor is not more than about 1 mm, a horizontal length of the light conversion structure is within a range which is 2 to 3 times a horizontal length of the light-emitting diode chip, and the light conversion structure includes a multi-layer reflection structure where insulation layers having different refractive indexes are alternately stacked.

### BRIEF DESCRIPTION OF THE DRAWINGS

Features will become apparent to those of skill in the art by describing in detail exemplary embodiments with reference to the attached drawings, in which:
FIG. 1 is a plan view schematically illustrating a light-emitting diode package according to embodiments;
FIG. 2 is a cross-sectional view taken along line A-A' in the light-emitting diode package of FIG. 1;
FIG. 3 is a schematic view for describing a substrate of the light-emitting diode package of FIG. 2;
FIG. 4 is a schematic view for describing a phosphor of the light-emitting diode package of FIG. 2;
FIG. 5 is a cross-sectional view schematically illustrating a light-emitting diode package according to embodiments;
FIG. 6 is a cross-sectional view schematically illustrating a light-emitting diode package according to embodiments;
FIG. 7 is a cross-sectional view schematically illustrating a light-emitting diode package according to embodiments;
FIG. 8 is a cross-sectional view schematically illustrating a light-emitting diode package according to embodiments;
FIG. 9 is a cross-sectional view schematically illustrating a light-emitting diode package according to embodiments; and
FIG. 10 is a schematic view schematically illustrating a directional angle of a light-emitting diode package according to embodiments.

### DETAILED DESCRIPTION

Hereinafter, embodiments will be described in detail with reference to the accompanying drawings. Like reference numerals refer to like elements in the drawings, and their repeated descriptions are omitted.

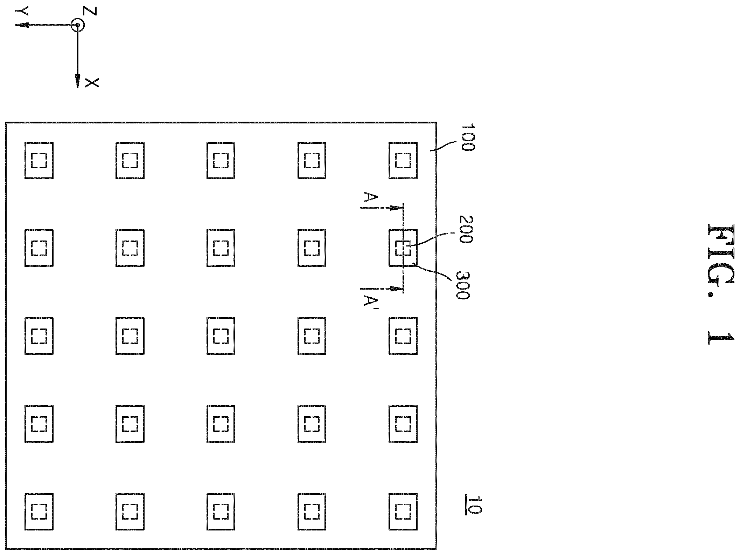

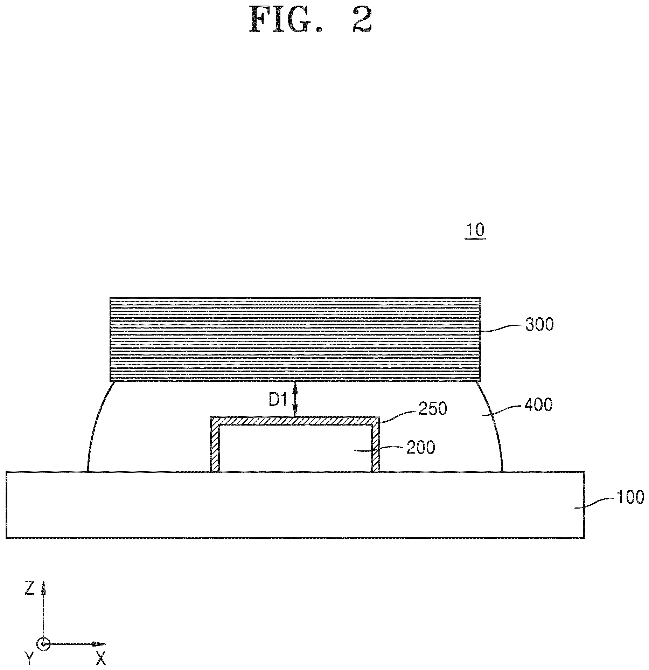

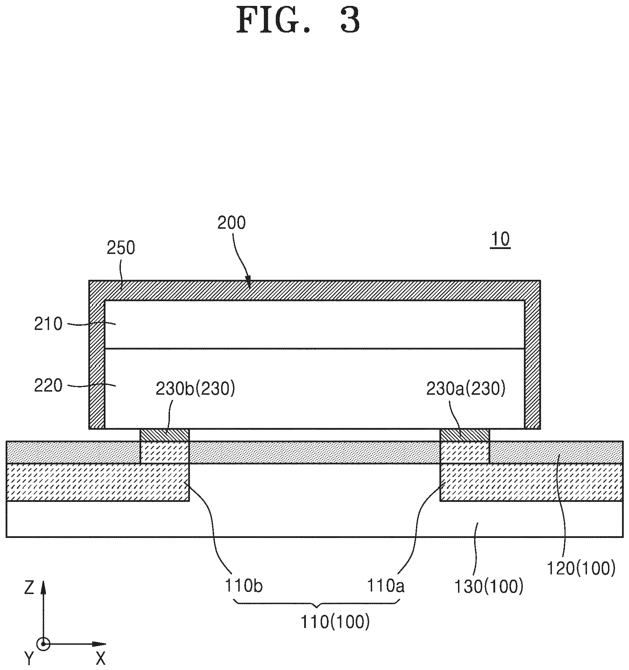

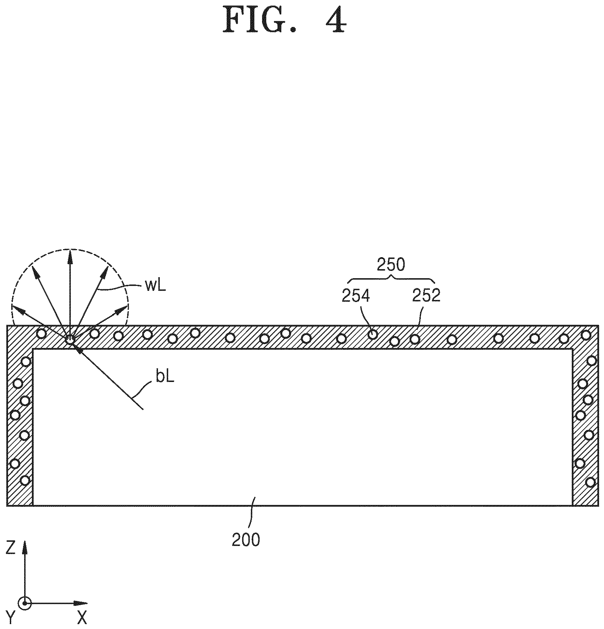

FIG. 1 is a plan view schematically illustrating a light-emitting diode package 10 according to embodiments. FIG. 2 is a cross-sectional view along line A-A' in of FIG. 1. FIG. 3 is a schematic view for describing a substrate of the light-emitting diode package 10 of FIG. 2. FIG. 4 is a schematic view for describing a phosphor of the light-emitting diode package 10 of FIG. 2.

Referring to FIGS. 1 to 4, the light-emitting diode package 10 according to an embodiment may include a substrate 100 and a plurality of light-emitting diode chips 200 which are arranged at a certain pitch on an upper surface of the substrate 100. A light conversion structure 300 may be disposed on each of the light-emitting diode chips 200, and a transparent element 400 may be disposed between the light-emitting diode chip 200 and the light conversion structure 300. For example, as illustrated in FIG. 1, the plurality of light-emitting diode chips 200 may be arranged in a matrix form on the substrate 100. In another example, the plurality of light-emitting diode chips 200 may be arranged in any suitable pattern, e.g., a hexagonal arrangement.

In the following drawings, an X-axis direction and a Y-axis direction may each represent a direction parallel to an upper surface or a lower surface of the substrate 100, and the X-axis direction and the Y-axis direction may be directions perpendicular to each other. A Z-axis direction may represent a direction perpendicular to the upper surface or the lower surface of the substrate 100. In other words, the Z-axis direction may be a direction perpendicular to the X-Y plane.

Also, in the following drawings, a first horizontal direction, a second horizontal direction, and a vertical direction may be understood as follows. The first horizontal direction may be understood as the X-axis direction, the second horizontal direction may be understood as the Y-axis direction, and the vertical direction may be understood as the Z-axis direction.

The substrate 100 may be a glass substrate. The glass substrate may be a printed circuit board (PCB) where an electrode pattern is formed in a base unit including, e.g., glass, hard glass, or quartz glass. The glass substrate may have a heat dissipation effect which is higher than that of a PCB using FR-4 formed by impregnating a glass fiber into resin and may have a relatively low coefficient of thermal expansion (CTE). Therefore, an electrode pattern which is more miniaturized than a conventional PCB using FR-4 may be implemented.

As illustrated in FIG. 3, the substrate 100 may include a base unit 130 and first and second electrode patterns 110a and 110b formed on an upper surface of the base unit 130. A coverage layer 120 totally covering the substrate 100 may be disposed on a surface of the substrate 100, e.g., the coverage layer 120 may cover and vertically overlap the entirety of the upper surface of the substrate 100, and the coverage layer 120 may be formed by coating a photo solder resist (PSR) ink. A partial region of each of the first electrode pattern 110a and the second electrode pattern 110b may pass through the coverage layer 120 and may be disposed to be exposed at a surface of the substrate 100, e.g., a portion of each of the first and second electrode patterns 110a and 110b may penetrate through the coverage layer 120 to have an upper surface coplanar with an upper surface of the coverage layer 120, and may be disposed to be exposed at a surface of the substrate 100. Thus, the first electrode pattern 110a and the second electrode pattern 110b may be electrically connected with the plurality of light-emitting diode chips 200 by a conductive adhesive layer, e.g., a solder bump.

Each of the plurality of light-emitting diode chips 200 may be mounted on the surface of the substrate 100, e.g., on the coverage layer 120. When seen from above, each of the plurality of light-emitting diode chips 200 may have a square shape or a rectangular shape. Each of the plurality of light-emitting diode chips 200 may include a growth substrate 210, an emission layer 220, and an electrode 230.

The growth substrate 210 may include an insulating, conductive, and semiconductor material, e.g., sapphire, Si, SiC, MgAl₂O₄, MgO, LiAlO₂, LiGaO₂, GaN, AlN, and a metal substrate. Sapphire is widely used as a nitride semiconductor growth substrate, and is a crystal which exhibits electrical insulating properties and has hexa-rhombo R3c symmetry.

The emission layer 220 may include a first conductivity type semiconductor layer, an active layer, and a second conductivity type semiconductor layer, which are sequentially arranged on a lower surface of the growth substrate 210. That is, the first conductivity type semiconductor layer, the active layer, and the second conductivity type semiconductor layer may be arranged apart from the growth substrate 210 in the order thereof, e.g., the first conductivity type semiconductor layer may be between the growth substrate 210 and the active layer. For example, as illustrated in FIG. 3, the emission layer 220 may be between the growth substrate 210 and the substrate 100, e.g., the emission layer 220 may be between the growth substrate 210 and the coverage layer 120.

For example, the first and second conductivity type semiconductor layers may respectively be an n-type semiconductor layer and a p-type semiconductor layer, and may include a nitride semiconductor. In another example, the first and second conductivity type semiconductor layers may be a p-type semiconductor layer and an n-type semiconductor layer, respectively. The first and second conductivity type semiconductor layers may have a composition formula of AlₓIn_{y}Ga_{(1-x-y)}N (0≤x<1, 0≤y<1, 0≤x+y<1), e.g., to include GaN, AlGaN, or InGaN.

The active layer may be a layer for emitting visible light (e.g., a wavelength range of about 350 nm to about 680 nm) and may include an undoped nitride semiconductor layer having a single or multiple quantum well structure. In some embodiments, the active layer may emit blue light. For example, the active layer may be formed in a multiple quantum well structure where the quantum barrier layer and the quantum well layer may each include AlₓIn_{y}Ga_{(1-x-y)}N (0≤x<1, 0≤y<1, 0≤x+y<1), may be alternately stacked, and may use a structure having a certain bandgap. An electron and a hole may be recombined by the quantum well structure to emit light. For example, the multiple quantum well structure may use a structure of InGaN/GaN. The first and second conductivity type semiconductor layers and the active layer may be formed by using a crystal growth process, e.g., metalorganic chemical vapor deposition (MOCVD), molecular beam epitaxy (MBE), or hydride vapor phase epitaxy (HVPE).

The light-emitting diode chip 200 may include a light-emitting diode chip having a flip-chip structure where the electrode 230 is disposed on only one surface thereof. In an embodiment, the electrode 230 may include first and second electrodes 230a and 230b, and the first and second electrodes 230a and 230b may be disposed on a surface of the light-emitting diode chip 200 that faces the substrate 100. The first and second electrodes 230a and 230b may be configured to respectively apply external power to the first and second conductivity type semiconductor layers, and may be provided to respectively ohmic-contact the first and second conductivity type semiconductor layers.

Each of the first and second electrodes 230a and 230b may be formed in a single-layer or multi-layer structure including a conductive material having a characteristic of ohmic-contact with the first and second conductivity type semiconductor layers. For example, the first and second electrodes 230a and 230b may be formed by a process of sputtering or depositing one or more materials of, e.g., gold (Au), silver (Ag), copper (Cu), zinc (Zn), aluminum (Al), indium (In), titanium (Ti), silicon (Si), germanium (Ge), tin (Sn), magnesium (Mg), tantalum (Ta), chromium (Cr), tungsten (W), ruthenium (Ru), rhodium (Rh), iridium (Ir), nickel (Ni), palladium (Pd), platinum (Pt), and transparent conductive oxide (TCO).

A phosphor 250 may be disposed on the light-emitting diode chip 200. According to embodiments, the phosphor 250 may be disposed to cover a lateral surface and an upper surface of the light-emitting diode chip 200. For example, as illustrated in FIG. 3, the phosphor 250 may cover an entirety of the lateral surface and the upper surface of the light-emitting diode chip 200 (e.g., the entire upper surface of the growth substrate 210 facing away from the emission layer 220 and the entire lateral surfaces of each of the emission layer 220 and the growth substrate 210 extending perpendicularly with respect to the upper surface of the growth substrate 210). The phosphor 250 may be provided in a one-body shape covering the lateral surface and the upper surface of the light-emitting diode chip 200, e.g., the phosphor 250 may continuously cover the upper and lateral surfaces of the light-emitting diode chip 200. The phosphor 250 may be provided in plurality and may be provided to cover each of the plurality of light-emitting diode chips 200.

The phosphor 250 may include two or more kinds of materials which provide light having different wavelengths. For example, the phosphor 250 may include a material where a green fluorescent powder is mixed with a red fluorescent powder. For example, the phosphor 250 may have a structure where a plurality of wavelength conversion layers are stacked. For example, the phosphor 250 may have a structure where a first wavelength conversion layer emitting green light and a second wavelength conversion layer emitting red light are stacked. Therefore, the phosphor 250 may convert light, emitted from the light-emitting diode chip 200, into white light or light having a certain (e.g., predetermined) wavelength.

According to embodiments, as illustrated in FIG. 4, the phosphor 250 may include a transmissive resin 252 and a wavelength conversion material 254. According to embodiments, the transmissive resin 252 may include, e.g., epoxy, silicone, strained silicone, urethane resin, oxetane resin, acryl, polycarbonate, polyimide, and a combination thereof. According to embodiments, the phosphor 250 may have electrically insulating properties.

In detail, referring to FIG. 4, the phosphor 250 may be configured to convert blue light bL, emitted from the light-emitting diode chip 200, into white light wL. Light emitted from the light-emitting diode chip 200 may be converted into the white light wL while passing through the wavelength conversion material 254. In this case, as the blue light bL is converted into the white light wL, the white light wL may be discharged in a lambertian shape. As a result, light passing through the phosphor 250 may be uniformly discharged (e.g., transmitted) to the outside of the phosphor 250.

As illustrated in FIG. 2, the light conversion structure 300 may be disposed on the light-emitting diode chip 200, e.g., the phosphor 250 may be between the light conversion structure 300 and the light-emitting diode chip 200. For example, as illustrated in FIG. 2, the light conversion structure 300 may extend in parallel to the upper surface of the light-emitting diode chip 200, while being vertically spaced apart a predetermined distance from the phosphor 250.

The light conversion structure 300 may be configured to reflect or absorb light passing through the phosphor 250. The light conversion structure 300 may absorb or reflect the light to change a path of the light.

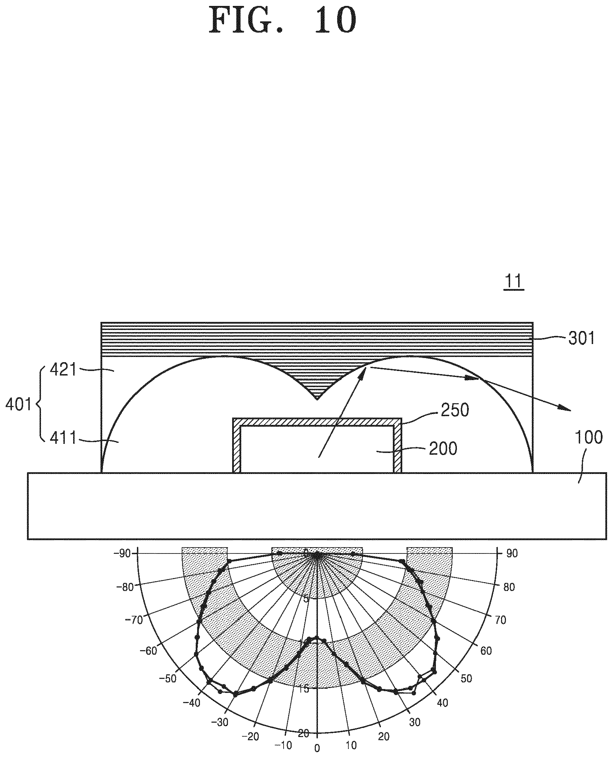

In detail, the light conversion structure 300 may change the path of the light so that the light passing through the phosphor 250 is discharged (e.g., directed or transmitted) toward a side surface of the light-emitting diode chip 200. According to embodiments, the light conversion structure 300 may allow the light emitted from the light-emitting diode chip 200 to have directionality having a batwing shape. For example, a path of light passing through the phosphor 250 may be changed so that light emitted at a 45-degree direction by the light conversion structure 300 is 1.2 times to 1.3 times stronger than light emitted in a vertical direction Z, as will be discussed in more detail below with reference to FIG. 10.

According to embodiments, the light conversion structure 300 may have a reflectance of about 50% or more.

According to embodiments, a horizontal length of the light conversion structure 300, e.g., in the X-axis direction, may be within a range which is 2 times to 3 times a horizontal length of the light-emitting diode chip 200, e.g., in the X-axis direction. When the horizontal length of the light conversion structure 300 is within the above indicated range, a directional angle of the light emitted from the light-emitting diode chip 200 may increase. When the horizontal length of the light conversion structure 300 is less than 2 times the horizontal length of the light-emitting diode chip 200, the directional angle of the light emitted from the light-emitting diode chip 200 may decrease. When the horizontal length of the light conversion structure 300 is greater than 3 times the horizontal length of the light-emitting diode chip 200, space efficiency may be reduced due to a large volume of the because of occupying a large volume the light conversion structure 300. According to embodiments, the horizontal length of the light conversion structure 300 may be within a range of about 1,300 µm to about 1,700 µm.

According to embodiments, the light conversion structure 300 may be disposed apart from an upper surface of the phosphor 250 by a certain distance. A separation distance D1 between the light conversion structure 300 and the phosphor 250 may not be more than about 1 mm. In this case, the separation distance D1 may be understood as the shortest vertical distance between the light conversion structure 300 and the phosphor 250. According to embodiments, a shortest distance between the upper surface of the phosphor 250 and a lowermost end of a lower surface of the light conversion structure 300 may not be more than about 1 mm. When the separation distance between the light conversion structure 300 and the phosphor 250 is greater than about 1 mm, the light uniformity of the light-emitting diode package 10 may be reduced. When the separation distance between the light conversion structure 300 and the phosphor 250 is less than about 1 mm, light emitted from the light-emitting diode chip 200 capable of being covered by the light conversion structure 300 may increase, thereby causing the emitted light to concentrate on the side surface of the light-emitting diode chip 200.

In some embodiments, the light conversion structure 300 may be provided in a multi-layer reflection structure shape. For example, the light conversion structure 300 may be provided as a distributed Bragg reflector (DBR). The light conversion structure 300 having the multi-layer reflection structure shape may have a structure where a first insulation layer and a second insulation layer having different refractive indexes are alternately stacked. That is, the light conversion structure 300 may have a multi-layer reflection structure where insulation layers having different refractive indexes are alternately stacked.

The first insulation layer and the second insulation layer may include a material having an insulating characteristic and a transmissive characteristic. For example, the light conversion structure 300 having a multi-layer reflection structure may include silicon oxide or silicon nitride. For example, the first and second insulation layers of the light conversion structure 300 may include SiO₂, SiN, SiOₓN_{y}, TiO₂, Si₃N₄, Al₂O₃, TiN, AlN, ZrO₂, TiAlN, or TiSiN. In an embodiment, the first insulation layer may include SiO₂, and the second insulation layer may include TiO₂. When the light conversion structure 300 is formed in the multi-layer reflection structure, the light conversion structure 300 may be formed in a more precise shape. For example, even when the lower surface of the light conversion structure 300 is formed in a tapered shape which progressively narrows downwardly in the vertical direction Z, the shape may be more precisely implemented by the multi-layer reflection structure.

In some embodiments, the light conversion structure 300 may include TiO₂. That is, the light conversion structure 300 may have a one-body shape including TiO₂. When the light conversion structure 300 includes TiO₂, the manufacturing cost may be reduced.

A transparent element 400 may be disposed between the light-emitting diode chip 200 and the light conversion structure 300. The transparent element 400 may surround the lateral surface (e.g., side surface) and the upper surface of the phosphor 250, and the light conversion structure 300 may be disposed on the transparent element 400. The transparent element 400 may include a material capable of transmitting light, e.g., silicon. The transparent element 400 may protect the light-emitting diode chip 200 from an external impact and may be configured so that light emitted from the light-emitting diode chip 200 refracts sidewards.

For example, as illustrated in FIG. 2, the light conversion structure 300 may include a lower surface (e.g., a surface facing the transparent element 400) having a flat shape. The lower surface of the light conversion structure 300 may be on (e.g., directly on) transparent element 400, and may have a horizontal length longer than the horizontal length of the light-emitting diode chip 200.

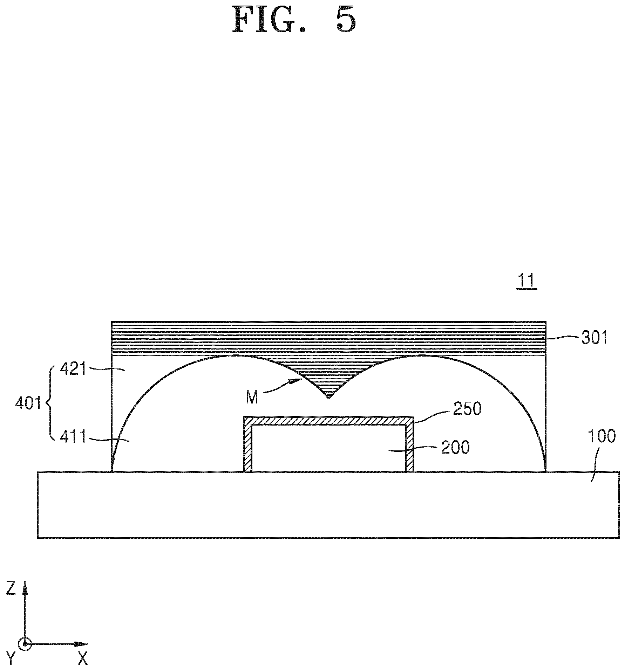

In another example, as will be discussed in more detail below with reference to FIGS. 5-9, the light conversion structure 300 may have a horizontal cross-sectional area which increases progressively as a level in a vertical direction increases. That is, the horizontal cross-sectional area (e.g., width in the X-axis direction) of the light conversion structure 300 may increase, as the vertical distance along the Z-axis direction from the substrate 100 increases, e.g., so a lowermost portion of the lower surface of the light conversion structure 300 may have a horizontal length smaller than that of the of the light-emitting diode chip 200 (while an upper portion of the light conversion structure 300 may have a horizontal length 2 times to 3 times greater than that of the light-emitting diode chip 200). For example, the light conversion structure 300 may have a shape where a center of the lower surface of the light conversion structure 300 protrudes toward the light-emitting diode chip 200, e.g., where the lower surface of the light conversion structure 300 has a narrow or sharp portion pointing toward the light-emitting diode chip 200 . When the light conversion structure 300 has a shape which protrudes toward the light-emitting diode chip 200, the light emitted from the light-emitting diode chip 200 may increase in angle incident on the light conversion structure 300 and angle reflected therefrom. Such embodiments of the light conversion structure 300 will be described below with reference to FIGS. 5-9.

FIG. 5 is a cross-sectional view schematically illustrating a light-emitting diode package 11 according to embodiments. Hereinafter, repeated descriptions of the light-emitting diode package 11 of FIG. 5 and the light-emitting diode package 10 described above with reference to FIGS. 1 to 4 are omitted, and a difference therebetween is mainly described.

Referring to FIG. 5, the light-emitting diode package 11 may include the substrate 100, the light-emitting diode chip 200, the phosphor 250, a transparent element 401, and a light conversion structure 301.

The transparent element 401 may include a first transparent element 411 and a second transparent element 421. The first transparent element 411 may cover a side surface and an upper surface of the phosphor 250, and the second transparent element 421 may surround a side surface of the first transparent element 411. According to embodiments, a refractive index of the first transparent element 411 may differ from that of the second transparent element 421. Also, the refractive index of the first transparent element 411 and the refractive index of the second transparent element 421 may be higher than that of the phosphor 250.

According to embodiments, the refractive index of the first transparent element 411 may be lower than that of the second transparent element 421. Therefore, light emitted from the light-emitting diode chip 200 may be primarily refracted while passing through the first transparent element 411 and may be secondarily refracted while passing through the second transparent element 421. A refraction direction of the light may be refracted in a direction in which the speed of all light is reduced. That is, the light may be refracted toward the substrate 100 while passing through the first transparent element 411 and the second transparent element 421.

A vertical cross-section of the light conversion structure 301 may have a shape where a slope of a lower surface thereof decreases progressively, and in a direction distancing from the center of the lower surface thereof. The light conversion structure 301 may have a shape where the lower surface thereof protrudes toward the light-emitting diode chip 200. That is, the lower surface of the light conversion structure 301 may have a shape which is sharp downwardly, e.g., a center of the lower surface of the light conversion structure 301 may include an apex or a sharp tip pointing toward the light-emitting diode chip 200.

The lower surface of the light conversion structure 301 may have a shape where a distance to an upper surface of the light-emitting diode chip 200 increases progressively in a direction distancing from the center of the lower surface thereof. For example, as illustrated in FIG. 5, a peripheral portion of the lower surface of the light conversion structure 301 (e.g., a portion not vertically overlapping the light-emitting diode chip 200 and a portion vertically overlappoing only an edge of the light-emitting diode chip 200) may be flat and parallel to the substrate 100 (i.e., at a constant distance from the substrate 100), and a central portion of the lower surface of the light conversion structure 301 (e.g., a portion vertically overlapping a center of the light-emitting diode chip 200) may be at a decreasing (e.g., gradually and continuously decreasing) distance from the upper surface of the light-emitting diode chip 200 (i.e., a distance from the central portion of the lower surface of the light conversion structure 301 to the upper surface of the light-emitting diode chip 200 may increase as a distance from the center of the lower surface of the light conversion structure 301 increases).

As further illustrated in FIG. 5, a valley M may be formed in the first transparent element 411. The first transparent element 411 may include the valley M which is formed in an upper portion of (e.g., above) a center of the light-emitting diode chip 200. The valley M may have a shape which is recessed toward the center of the light-emitting diode chip 200 from the first transparent element 411 disposed on the upper surface of the light-emitting diode chip 200. Therefore, the light conversion structure 301 may have a shape which is downward sharp while filling the valley M, e.g., the shape of the vertical cross-section of the light conversion structure 301 may be complementary with respect to the shape of the valley M (e.g., and a central portion of the upper surface of the first transparent element 411).

According to embodiments, a vertical cross-section the first transparent element 411 may have a double dome shape where two hills are continuously formed on (e.g., above) the center of the light-emitting diode chip 200. An interval narrowing between the hills may correspond to the valley M described above.

Because the transparent element 401 is configured with the first transparent element 411 and the second transparent element 421, and the refractive index of the first transparent element 411 differs from that of the second transparent element 421, the light emitted from the light-emitting diode chip 200 may be refracted twice. Also, the refractive index of the second transparent element 421 may be greater than that of the first transparent element 411, and thus, the light may be irradiated (e.g., transmitted) toward the side surface of the light-emitting diode chip 200, thereby increasing the directional angle of the light.

Also, the valley M may be formed in an upper surface of the first transparent element 411, and the light conversion structure 301 may have a shape which is downward sharp while filling the valley M. When the light emitted from the light-emitting diode chip 200 is reflected, an incident angle on the light conversion structure 301 and a reflection angle from the light conversion structure 301 may increase based on the shape of the light conversion structure 301. Therefore, the light may be reflected from the light conversion structure 301 toward the side surface of the light-emitting diode chip 200 (e.g., toward a region of the substrate 100 that is laterally spaced apart from the side surface of the light-emitting diode chip 200), thereby increasing the directional angle of the light emitted from the light-emitting diode chip 200.

Also, the transparent element 401 may be formed on the light-emitting diode chip 200 by a dispensing process. The first transparent element 411 including the valley M may be formed by dispensing the transparent element 401 on the light-emitting diode chip 200 (i.e., on the phosphor 250). Also, the light conversion structure 301 may be formed on the first transparent element 411, and thus, the light conversion structure 301 may have a downward sharp shape.

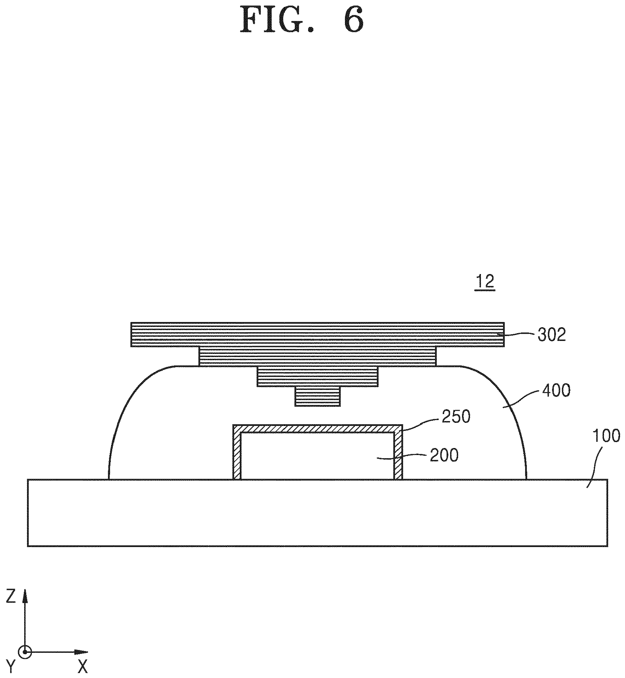

FIG. 6 is a cross-sectional view schematically illustrating a light-emitting diode package 12 according to embodiments. Hereinafter, repeated descriptions of the light-emitting diode package 12 of FIG. 6 and the light-emitting diode package 10 described above with reference to FIGS. 1 to 4 are omitted, and a difference therebetween is mainly described.

Referring to FIG. 6, the light-emitting diode package 12 may include the substrate 100, the light-emitting diode chip 200, the phosphor 250, the transparent element 400, and a light conversion structure 302.

According to embodiments, as illustrated in FIG. 6, a horizontal cross-sectional area of the light conversion structure 302 may have a shape which discontinuously increases as a level in a vertical direction Z increases. The shape may be understood as a cascade type (i.e., a staircase type). That is, a lower surface of the light conversion structure 302 may have a staircase shape where a vertical level of the lower surface thereof increases progressively in a direction distancing from the center of the lower surface of the light conversion structure 302 (e.g., each portion of the lower surface of the light conversion structure 302 facing the substrate 100 may be flat).

When the lower surface of the light conversion structure 302 has a staircase shape, it may be easy to manufacture the light conversion structure 302. Further, a path of light may be set so that light emitted from the light-emitting diode chip 200 is reflected toward a side surface of the light-emitting diode chip 200.

For example, when the light conversion structure 302 has this shape, the light conversion structure 302 may be first disposed on the light-emitting diode chip 200 and the phosphor 250, and then, by coating the transparent element 400 therebetween, the light-emitting diode package 12 may be formed. In another example, the light-emitting diode chip 200 and the phosphor 250 may be formed, and the transparent element 400 may be dispensed on the phosphor 250, and then, the light conversion structure 302 including the lower surface having a staircase shape may be formed.

For example, as illustrated in FIG. 6, the transparent element 400 may be a single structure with an opening accommodating the light conversion structure 302 (e.g., an opening having a complementary shape with respect to the light conversion structure 302). In another example, the transparent element may include a first transparent element and a second transparent element (as described above with reference to FIG. 5) and may have a shape where a valley is formed.

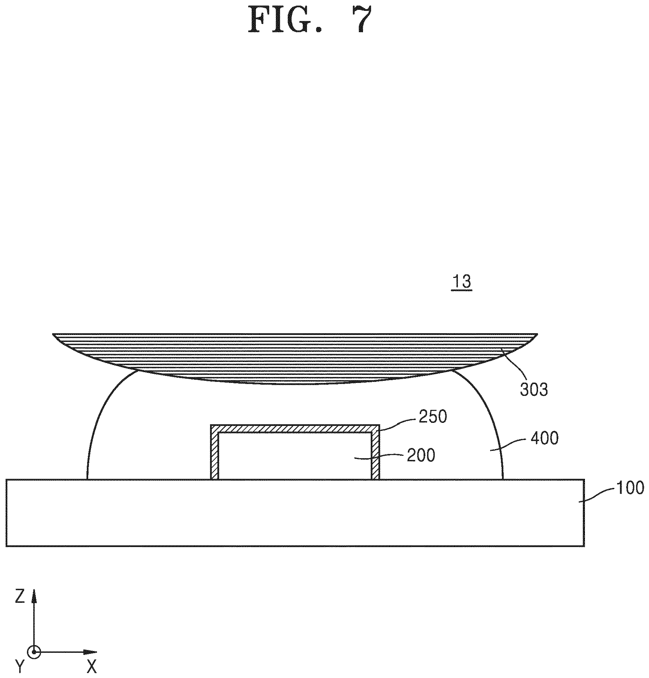

FIG. 7 is a cross-sectional view schematically illustrating a light-emitting diode package 13 according to embodiments. Hereinafter, repeated descriptions of the light-emitting diode package 13 of FIG. 7 and the light-emitting diode package 10 described above with reference to FIGS. 1 to 4 are omitted, and a difference therebetween is mainly described.

Referring to FIG. 7, the light-emitting diode package 13 may include the substrate 100, the light-emitting diode chip 200, the phosphor 250, the transparent element 400, and a light conversion structure 303.

According to embodiments, as illustrated in FIG. 7, the light conversion structure 303 may have a parabolic shape which is downward convex, e.g., the curved surface of the light conversion structure 303 may face (e.g., and directly contact) the transparent element 400. That is, a lower surface of the light conversion structure 303 may have a shape where a slope of the lower surface thereof increases progressively and continuously in a direction distancing from the center of the lower surface thereof. A distance between the lower surface of the light conversion structure 303 and an upper surface of the light-emitting diode chip 200 may increase progressively in a direction distancing from the center of the lower surface of the light conversion structure 303.

When the light conversion structure 303 has this shape, a gentle slope may be formed in the center of the lower surface of the light conversion structure 303 and a steep slope may be formed in an outer portion of the lower surface of the light conversion structure 303. Thus, light emitted from the light-emitting diode chip 200 may be efficiently reflected toward a side surface thereof.

For example, as illustrated in FIG. 7, the transparent element 400 may be a single structure with an opening accommodating the light conversion structure 303 (e.g., an opening having a complementary shape with respect to the light conversion structure 303). In another example, the transparent element may include a first transparent element and a second transparent element (as described above with reference to FIG. 5) and may have a shape where a valley is formed.

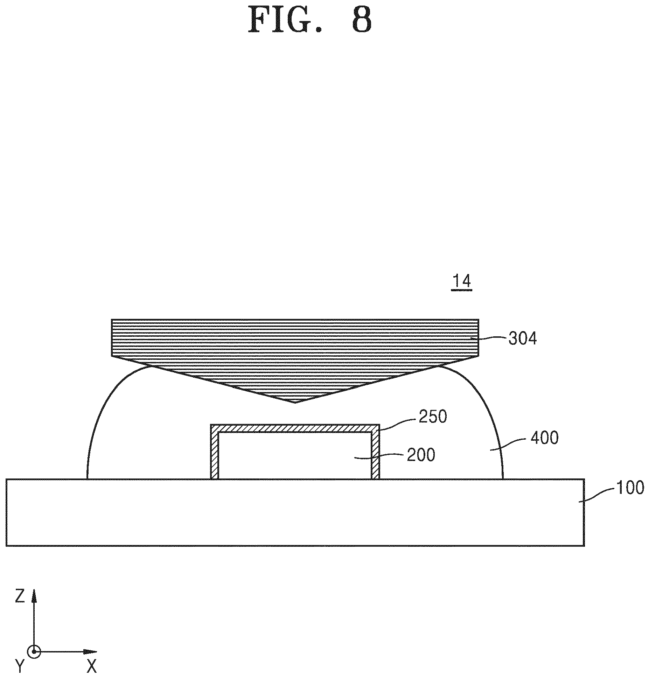

FIG. 8 is a cross-sectional view schematically illustrating a light-emitting diode package 14 according to embodiments. Hereinafter, repeated descriptions of the light-emitting diode package 14 of FIG. 8 and the light-emitting diode package 10 described above with reference to FIGS. 1 to 4 are omitted, and a difference therebetween is mainly described.

Referring to FIG. 8, the light-emitting diode package 14 may include the substrate 100, the light-emitting diode chip 200, the phosphor 250, the transparent element 400, and a light conversion structure 304.

According to embodiments, as illustrated in FIG. 8, the light conversion structure 304 may have a shape where a lower surface thereof protrudes toward the light-emitting diode chip 200. In this case, a vertical cross-section of the light conversion structure 304 may have a triangular shape where a center of the lower surface thereof protrudes toward the light-emitting diode chip 200. Therefore, a slope of the lower surface of the light conversion structure 304 may be constant regardless of the distance from the center of the lower surface thereof. A vertical level of the lower surface of the light conversion structure 304 may increase progressively in a direction distancing from the center of the lower surface thereof.

When the lower surface of the light conversion structure 304 has a triangular shape which protrudes downwardly, it may be easy to manufacture the light conversion structure 304 and a slope of the lower surface of the light conversion structure 304 may be constant. Thus, a path of light emitted from the light-emitting diode chip 200 may be more easily predicted.

For example, as illustrated in FIG. 8, the transparent element 400 may be a single structure with an opening accommodating the light conversion structure 304 (e.g., an opening having a complementary shape with respect to the light conversion structure 304). In another example, the transparent element may include a first transparent element and a second transparent element (as described above with reference to FIG. 5) and may have a shape where a valley is formed.

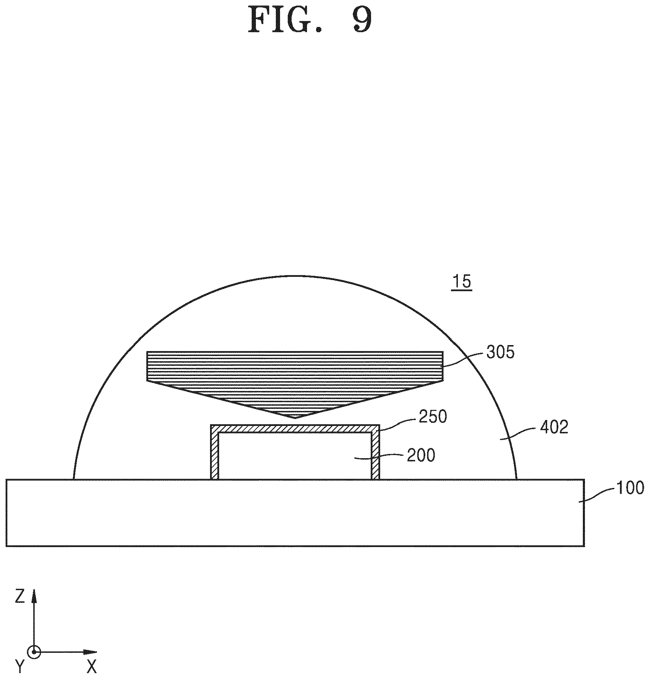

FIG. 9 is a cross-sectional view schematically illustrating a light-emitting diode package 15 according to embodiments. Hereinafter, repeated descriptions of the light-emitting diode package 15 of FIG. 9 and the light-emitting diode package 10 described above with reference to FIGS. 1 to 4 are omitted, and a difference therebetween is mainly described.

Referring to FIG. 9, the light-emitting diode package 15 may include the substrate 100, the light-emitting diode chip 200, the phosphor 250, a transparent element 402, and a light conversion structure 305.

According to embodiments, as illustrated in FIG. 9, the transparent element 402 may be formed to cover all of the light conversion structure 305. That is, the transparent element 402 may be formed on the light conversion structure 305 so that the light conversion structure 305 is disposed in the transparent element 402. Because the transparent element 402 covers all of the light conversion structure 305, even when light emitted from the light-emitting diode chip 200 is not irradiated onto the light conversion structure 305, the light may concentrate on a side surface thereof by using refraction by the transparent element 402.

The light conversion structure 305 may have a shape where the lower surface thereof protrudes toward the light-emitting diode chip 200. For example, the light conversion structure 305 is not limited to the illustration of FIG. 9 and may have various shapes, e.g., any of the shapes of FIGS. 5-8 described above.

FIG. 10 is a view schematically illustrating a directional angle of a light-emitting diode package according to embodiments. FIG. 10 is a graph showing an effect of the light-emitting diode package 11 illustrated in FIG. 5 among various embodiments of a light-emitting diode package according to embodiments. The illustrated effect is not limited to the light-emitting diode package 11 illustrated in FIG. 5, and the light-emitting diode packages illustrated in FIGS. 6 to 9 may realize an effect which is substantially the same as or similar to the effect of the light-emitting diode package 11.

Referring to FIG. 10, light emitted from the light-emitting diode chip 200 may be reflected by the lower surface of the light conversion structure 301. Since a portion of the lower surface of the light conversion structure 301 protrudes downwardly toward the light-emitting diode chip 200, light from the light-emitting diode chip 200 that is incident on the portion that protrudes a downwardly may be reflected toward the side surface of the light-emitting diode chip 200 (e.g., toward a region laterally spaced apart from the side surface of the light-emitting diode chip 200). Also, the reflected light may be refracted toward the substrate 100 while sequentially passing through the transparent element 411 and the second transparent element 421. Therefore, the amount of light emitted from the light-emitting diode chip 200 and transmitted toward the side surface of the light-emitting diode chip 200 may be increased.

Therefore, as in the graph shown in the lower region of FIG. 10, strong light may be emitted in a direction in which an angle of about 40 degrees to about 60 degrees is formed with respect to the substrate 100 (e.g., so when the light emitted from the light-emitting diode chip 200 is at an angle of about 40 degrees to about 60 degrees with respect to the substrate 100, the light reflected from the light conversion structure 301 is at its maximal strength and efficiency). A shape of the graph may be referred to as a batwing shape which is a wing shape of a bat. As described above, when the light emitted from the light-emitting diode chip 200 has the batwing shape, this may denote that a directional angle of the emitted light increases and may denote the efficiency of a light-emitting diode package increases.

By way of summation and review, because a liquid crystal display panel of each liquid crystal display device is a light-receiving device (which does not self-emit light), a backlight unit for irradiating light onto the liquid crystal display panel from a region under the liquid crystal display panel is needed. For example, the backlight unit may be configured with a light-emitting diode (LED) lamp, a light guide panel, a reflective sheet, and an optical sheet.

Therefore, embodiments provide a light-emitting diode package which emits directional light. That is, in a light-emitting diode package, according to embodiments, a light conversion structure is disposed on a phosphor, a transparent element is disposed therebetween, and the light conversion structure is formed to include a downwardly sharp shape, thereby increasing the amount of light concentrated (e.g., directed toward) a side surface (e.g., a side region laterally spaced apart from a side surface of a light-emitting diode chip).

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A light-emitting diode package, comprising:
a substrate;
a light-emitting diode chip on the substrate;
a phosphor surrounding a side surface and an upper surface of the light-emitting diode chip;
a light conversion structure on the phosphor; and
a transparent element between the phosphor and the light conversion structure.

2. The light-emitting diode package as claimed in claim 1, wherein the light conversion structure has a shape where a width of a horizontal cross-sectional area thereof increases progressively as a level in a vertical direction increases.

3. The light-emitting diode package as claimed in claim 2, wherein the transparent element includes a valley in an upper portion thereof, the valley vertically overlapping a center of the light-emitting diode chip.

4. The light-emitting diode package as claimed in claim 3, wherein:
the transparent element includes a first transparent element and a second transparent element, the first transparent element surrounding a side surface and an upper surface of the phosphor, and the second transparent element surrounding a side surface of the first transparent element, and
a refractive index of the first transparent element is lower than a refractive index of the second transparent element.

5. The light-emitting diode package as claimed in claim 3 or 4, wherein a lower surface of the light conversion structure has a shape where a slope thereof decreases progressively in a direction distancing from a center of the lower surface thereof.

6. The light-emitting diode package as claimed in claim 3, wherein the light conversion structure includes a lower surface having a downward convex shape.

7. The light-emitting diode package as claimed in any one of claims 1 to 6, wherein the transparent element covers a side surface and an upper surface of the light conversion structure.

8. The light-emitting diode package as claimed in any one of claims 1 to 7, wherein the light conversion structure and the phosphor are spaced apart from each other in a vertical direction, a shortest distance between a lower surface of the light conversion structure and an upper surface of the phosphor is about 1 mm or less.

9. The light-emitting diode package as claimed in any one of claims 1 to 8, wherein a horizontal width of the light conversion structure is 2 times to 3 times a horizontal width of the light-emitting diode chip.

10. The light-emitting diode package as claimed in any one of claims 1 to 9, wherein the light conversion structure includes a multi-layer reflection structure, the multi-layer reflection structure including a stack of alternating insulation layers having different refractive indexes.

11. The light-emitting diode package as claimed in claim 10, wherein:
the light conversion structure has a horizontal cross-sectional area which discontinuously increases as a level in a vertical direction increases, and
a lower surface of the light conversion structure has a staircase shape where a vertical level of the lower surface thereof increases progressively in a direction distancing from a center of the lower surface of the light conversion structure.

12. The light-emitting diode package as claimed in claim 1, wherein:
the transparent element comprises a first transparent element and a second transparent element,
the first transparent element covers a side surface and an upper surface of the phosphor, the first transparent element having a shape including a valley that vertically overlaps a center of the light-emitting diode chip,
the second transparent element surrounds the first transparent element, and
the light conversion structure fills the valley of the first transparent element and covers an upper surface of the second transparent element, a lower surface of the light conversion structure having a shape which protrudes downwardly toward the center of the light-emitting diode chip.

13. The light-emitting diode package as claimed in claim 12, wherein a refractive index of the first transparent element is lower than a refractive index of the second transparent element.

14. The light-emitting diode package as claimed in claim 12 or 13, wherein a vertical cross-section of the light conversion structure has a triangular shape, a center of the lower surface of the light conversion structure protruding toward the light-emitting diode chip.

15. The light-emitting diode package as claimed in claim 1, wherein:
the phosphor includes a wavelength conversion material,
the transparent element comprises a first transparent element and a second transparent element,
the first transparent element covers a side surface and an upper surface of the phosphor, the first transparent element having a shape including a valley that vertically overlaps a center of the light-emitting diode chip;
the second transparent element surrounds the first transparent element and has a refractive index higher than a refractive index of the first transparent element; and
the light conversion structure fills the valley of the first transparent element and covers an upper surface of the second transparent element, a lower surface of the light conversion structure having a shape which protrudes downwardly toward the center of the light-emitting diode chip,
the light conversion structure and the phosphor are spaced apart from each other in a vertical direction, a shortest distance between the lower surface of the light conversion structure and the upper surface of the phosphor is about 1 mm or less,
a horizontal length of the light conversion structure is 2 times to 3 times a horizontal length of the light-emitting diode chip, and
the light conversion structure includes a multi-layer reflection structure, the multi-layer reflection structure including a stack of alternating insulation layers having different refractive indexes.
